# EUROPEAN PATENT APPLICATION

(11) **EP 4 199 114 A1**
(43) Date of publication of application: **21.06.2023**
(21) Application number: 22208044.2
(22) Date of filing: 17.11.2022
(51) Int. Cl.: H01L 29/775, H01L 29/423, H01L 29/417, H01L 29/06, H01L 27/06, H01L 21/336, H01L 21/822, H01L 21/74, H01L 21/768, H01L 21/8234, B82Y 10/00

(54) **WRAP-AROUND CONTACTS FOR STACKED TRANSISTORS**

(30) Priority: 20.12.2021 US 202117556750
(71) Applicant: INTEL Corporation, Santa Clara, CA 95054 (US)
(72) Inventor: KAVALIEROS, Jack T., Portland, OR 97229 (US); RADOSAVLJEVIC, Marko, Portland, OR 97229 (US); DEWEY, Gilbert, Beaverton, OR 97006 (US); RACHMADY, Willy, Beaverton, OR 97007 (US); MORROW, Patrick, Portland, OR 97229 (US); HUANG, Cheng-Ying, Hillsboro, OR 97124 (US); THOMAS, Nicole K., Portland, OR 97209 (US)
(74) Representative: HGF

(57) **Abstract**

Techniques to form wrap-around contacts in a stacked transistor architecture. An example includes a first source or drain region and a second source or drain region spaced from and over the first source or drain region. A conductive contact is on a top surface of the second source or drain and extends down one or more side surfaces of the second source or drain region such that the conductive contact is laterally adjacent to a bottom surface of the second source or drain region. In some cases, the conductive contact is also on a top surface of the first source or drain region, and/or extends down a side surface of the first source or drain region. In some cases, a second conductive contact is on a bottom surface of the first source or drain region, and may extend up a side surface the first source or drain region.

## Description

### FIELD OF THE DISCLOSURE

The present disclosure relates to integrated circuits, and more particularly, to wrap-around contacts for stacked transistors.

### BACKGROUND

Integrated circuitry continues to scale to smaller feature dimensions and higher transistor densities. A more recent development with respect to increasing transistor density is generally referred to as three-dimensional (3D) integration, which expands transistor density by exploiting the z-dimension (build upwards rather than laterally outwards in the x- and y-dimensions). Some such 3D integrated circuits are formed utilizing a technique known as layer transfer. Such layer transfer may include, for instance, bond and hydrogen-based or hydrogen/helium based cleave techniques. Other 3D integrated circuits are formed by separately forming transistors on two distinct wafers (sometimes referred to as host and donorwafers or substrates), the two wafers being bonded together via an oxide bonding layer. Excess wafer material is removed by chemical-mechanical polish (CMP) operations. Still other 3D integrated circuits are achieved by forming transistors on upper and lower regions of the same fin structure. In any such cases, such 3D integration schemes provide a stacked transistor architecture and give rise to a number of non-trivial issues.

### BRIEF DESCRIPTION OF THE DRAWINGS

Figures 1a-1c are each a cross-sectional side view of an example integrated circuit including stacked transistor architecture configured with wrap-around contacts, in accordance with an embodiment of the present disclosure.
Figures 2a-2g are cross-sectional side views of example wrap-around contacts that extend down both sides of a source or drain region in a stacked transistor architecture, in accordance with some embodiments of the present disclosure.
Figures 3a-3b are cross-sectional side views of example wrap-around contacts on asymmetrically sized source or drain regions in a stacked transistor architecture, in accordance with some embodiments of the present disclosure.
Figures 4a-4g are cross-sectional side views of example wrap-around contacts that extend down one side of a source or drain region in a stacked transistor architecture, in accordance with some embodiments of the present disclosure.
Figures 5a-5b are cross-sectional side views of example wrap-around contacts on top and side surfaces of variously shaped source or drain regions in a stacked transistor architecture, in accordance with some embodiments of the present disclosure.
Figure 6 is a flowchart of a fabrication process for an integrated circuit including stacked transistor architecture configured with wrap-around contacts, in accordance with an embodiment of the present disclosure.
Figure 7a-j are cross-sectional side views that collectively illustrate an example process for forming source and drain regions in an integrated circuit including stacked transistor architecture configured with wrap-around contacts, in accordance with an embodiment of the present disclosure.
Figures 8a-1 to 8d-4 and 9a-1 to 9c-4 are cross-sectional side views that collectively illustrate example processes for forming wrap-around contacts in an integrated circuit including stacked transistor architecture, in accordance with some embodiments of the present disclosure.
Figure 10 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may be tapered and/or have rounded corners), and some features may have surface topology or otherwise be non-smooth, given real world limitations of the processing equipment and techniques used.

### DETAILED DESCRIPTION

Techniques are provided herein to form wrap-around contacts in a stacked transistor architecture. An example includes a first source or drain region and a second source or drain region spaced from and over the first source or drain region. A conductive contact is on a top surface of the second source or drain and extends down one or more side surfaces of the second source or drain region such that the conductive contact is laterally adjacent to a bottom surface of the second source or drain region. In some cases, the conductive contact is also on a top surface of the first source or drain region, and/or extends down a side surface of the first source or drain region. In some cases, a second conductive contact is on a bottom surface of the first source or drain region, and may extend up a side surface the first source or drain region. The techniques can be used, for example, to provide a stacked transistor pair, where the wrap-around contact provides a common drain output. Numerous wrap-around contact configurations will be appreciated in light of this disclosure.

### General Overview

As previously noted above, there remain a number of non-trivial challenges with respect to stacked transistor architecture. For instance, consider the example case of a stacked architecture for providing a complementary metal oxide semiconductor (CMOS) logic cell such as an inverter, in which the drains of a bottom p-type metal oxide semiconductor (PMOS) and a top n-type metal oxide semiconductor (NMOS) transistors are connected together by an intra-cell vertical interconnect to provide a common-drain output of the inverter. However, continued scaling of gate pitch and the stacked transistors causes the aspect ratio of such vertical interconnects to increase (they get taller and narrower), which in turn decreases contact area of those interconnects, which in turn increases resistance of those interconnects, which in turn impacts transistor performance and slows down the logic circuits. One possible approach to increase surface area of the interconnect and thus decrease its contact resistance includes using a dry etch to punch-through the top drain prior to the contact metal deposition, and then depositing contact metal within the punch-through area to connect the top and bottom drains. Another possible option is allowing the epitaxial (epi) nodules on the same side of drain recess to merge vertically thus connecting multiple nanoribbons on that side, but those epi nodules are not allowed to merge laterally with the epi nodules growing from the multiple nanoribbons of the adjacent channel region on the other side of drain recess. This non-merged epi nodules leaves space for contact metal deposition (similar to the punch-thru approach). While such approaches may provide larger contact area as compared to standard techniques, thus lowering contact resistance, they are still problematic. For instance, the dry etch of the punch-through approach may potentially damage the top drain and contact quality, and the non-merged epi approach may cause variation of epi (drain) nodule morphology which may in turn increase variability of contact resistance.

Thus, techniques are provided herein for forming wrap-around contact structures for stacked transistors. In an embodiment, a wrap-around contact structure is provided to both (1) reduce contact resistance by increasing contact area for the top source or drain region and (2) form a vertical interconnect to the bottom source or drain region. Note that the techniques can also be used to provide a wrap-around contact introduced from the backside of the integrated circuit to both (1) reduce contact resistance by increasing contact area for the bottom source or drain region and (2) form a vertical interconnect to the top source or drain region. Thus, the techniques can be used to provide a vertical interconnect to connect top and bottom transistors of a given cell or other stacked transistor arrangement, and to increase contact area of that interconnect thereby reducing contact resistance for stacked transistors, and improve transistor on-state performance. In addition, the techniques may provide less process damage than a punch-through approach and less epi variation than a non-merged epi approach. In addition, the resulting wrap-around contact resistance and the vertical interconnect resistance may be less sensitive to gate pitch scaling, which allows for continued scaling.

The wrap-around contact can have a number of configurations, depending on factors such as whether it is a frontside or backside contact, and how it is to contact the top and bottom epi regions. Consider the example case of an NMOS transistor configured with n-type epitaxial source and drain regions (n-epi) over a PMOS transistor configured with p-type epitaxial source and drain regions (p-epi). In some such cases, a frontside wrap-around contact (or electrode) is in contact with top and side surfaces of the n-epi. Note the contacted side surfaces of the n-epi run in the same lateral direction as the channel region (and orthogonal to the gate). In this sense, the frontside wrap-around contact effectively straddles the n-epi. In some such embodiments, the frontside wrap-around contact extends down to contact a top surface of the p-epi of the bottom transistor. In this manner, the n-epi and p-epi are connected to form, for example, a common-drain output. In some such cases, the frontside wrap-around contact also extends down side surfaces of the p-epi, just as it does with side surfaces of the n-epi. In such a case, the frontside wrap-around contact completely wraps around the n-epi and effectively straddles the p-epi. In other examples, there is a dielectric isolation structure between the n-epi and the p-epi, such that the bottom surface of the n-epi and the top surface of the p-epi are covered by the isolation structure. In such cases, the frontside wrap-around contact can be on top and side surfaces of the n-epi but only on side surfaces of the p-epi.

In other such cases, a backside wrap-around contact (or electrode) is in contact with bottom and side surfaces of the p-epi, and may extend upward to contact bottom and/or side surfaces of the n-epi, in a similar fashion as described above with respect to a frontside wrap-around contact. All of the variations noted above equally apply here, but with respect to the backside wrap-around contact. Further note that, while there are some benefits to have n-epi over p-epi (e.g., n-epi materials that are more temperature sensitive and susceptible to crystalline damage are not subjected to thermal budget of p-epi), the present description is not intended to be limited to such configurations; rather, other embodiments may have p-epi over n-epi. To this end, example embodiments may refer to top-epi and bottom-epi, rather than n-epi or p-epi, and the top-epi and bottom-epi may be oppositely-doped (e.g., bottom-epi is p-doped and top-epi is n-doped, or vice-versa) or asymmetrically-doped (e.g., bottom-epi is p-doped to a first concentration and top-epi is p-doped to a second concentration, or bottom-epi is n-doped with arsenic and top-epi is n-doped with phosphorus) or symmetrically-doped (e.g., bottom-epi and top-epi are both p-doped or n-doped to the same concentration).

In still other examples, there is a dielectric isolation structure between the top-epi and the bottom-epi, and each of the bottom-epi and the top-epi are separately contacted, so there is no common contact. In one such example case, a frontside wrap-around contact can be on top and side surfaces of the top-epi as well as on a top surface of the dielectric isolation structure, and a backside wrap-around contact can be on bottom and side surfaces of the bottom-epi and have its top surface abutted to a bottom surface of the dielectric isolation structure. In such an example case, neither the frontside or backside wrap-around contact extends past the dielectric isolation structure.

In still other examples, there is no dielectric isolation structure between the n-epi and the p-epi, and each of the p-epi and the n-epi are separately contacted but the contacts touch (so there is effectively a common contact). In one such example case, a frontside wrap-around contact can be on top and side surfaces of the top-epi, and a backside wrap-around contact can be on bottom and side surfaces of the bottom-epi and have its top surface abutted to the bottom of the frontside wrap-around contact. In such a case, the bottom surface of the top-epi may be contacted by either of the frontside wrap-around contact or the backside wrap-around contact; likewise, the top surface of the bottom-epi may be contacted by either of the frontside wrap-around contact or the backside wrap-around contact. In some such cases, the bottom surface of the top-epi is contacted by the frontside wrap-around contact, the top surface of the bottom-epi is contacted by the backside wrap-around contact. In other such cases, the bottom surface of the top-epi and the top surface of the bottom-epi are both contacted by the frontside wrap-around contact. In still other such cases, the bottom surface of the top-epi and the top surface of the bottom-epi are both contacted by the backside wrap-around contact. In any such cases, the frontside and backside wrap-around contacts directly contact one another.

In still other examples, with or without a dielectric isolation layer between the bottom-epi and top-epi, frontside and/or backside wrap-around contacts are only on one side of the bottom-epi and/or top-epi. For instance, in one such case, a frontside wrap-around contact is on top and one or more left-side surfaces of the top-epi, and dielectric material is on one or more right-side surfaces of the top-epi. In one such case, dielectric material is on top, left-side, and right-side surfaces of the bottom-epi, and the bottom-epi is either not contacted or backside contacted on its bottom surface. In another such case, the frontside wrap-around contact extends down to also contact one or more left-side surfaces of the bottom-epi, wherein the frontside contact may also contact bottom and top surfaces of the top-epi and bottom-epi, respectively, if those surfaces are not blocked (e.g., by a dielectric isolation structure). In another such case, the frontside wrap-around contact lands on an isolation structure or etch stop, and a backside wrap-around contact is on bottom and one or more right-side surfaces of the bottom-epi, and dielectric material is on one or more left-side surfaces of the bottom-epi. In another such case, the frontside wrap-around contact lands on a portion of a backside wrap-around contact that is on bottom and one or more left-side surfaces of the bottom-epi, and dielectric material is also on one or more right-side surfaces of the bottom-epi.

Note that in the case of a frontside vertical interconnect from the top-epi to the bottom-epi, the top-epi may be smaller in its span relative to the bottom-epi span, according to some embodiments. Similarly, in the case of a backside vertical interconnect from the bottom-epi to the top-epi, the bottom-epi may be smaller in its span relative to the top-epi span, according to some embodiments. Such embodiments can be described as having a wrap-around contact configuration with asymmetric top and bottom epi spans. The epi span refers to the longest horizonal distance between opposing side surfaces of a given epi region, the side surfaces being those side surfaces that run in the same general direction as the channel region (orthogonal to the gate) and may be contacted by a wrap-around contact.

Further note that the shape of the epi regions can vary from one embodiment to the next. For instance, in some cases having a nanoribbon channel region, the epi grown on each nanoribbon can form ellipsoid. Multiple ellipsoids of the top-epi can merge together and form a wavy-like epi span; same for the bottom-epi. In another example, a given epi region may have a diamond or pyramid shape, or other faceted shape. In another example, a given epi region could have a rectangular shape or otherwise fairly vertical side surfaces if the epi growth is a confined growth (such as growth constrained by sidewalls of a recess or neighboring layer). Further note that the top and bottom epi might look very differently.

Further note that a backside contact to a given bottom-epi might or might not be present in a specific structure depending on whether backside routing is used, and regardless of whether a frontside wrap-around contact is in contact with that bottom-epi. Likewise, a frontside contact to a given top-epi might or might not be present in a specific structure depending on whether frontside routing is used, and regardless of whether a backside wrap-around contact is in contact with that top-epi.

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); electron energy loss spectroscopy (EELS); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools (e.g., SEM or TEM) can be used to image wrap-around contacts having one or more attributes or features as variously described herein.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element(s) or feature(s) as illustrated in the figures. The spatially relative terms are intended to encompass different orientations of the integrated circuit structure in use or operation in addition to the orientation depicted in the figures. The structure may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure (e.g., device layer or interconnect layer), with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., silicon germanium is compositionally different than silicon), or by way of one material having all the same elements as a second material but at least one of those elements is intentionally provided at a different concentration in one material relative to the other material (e.g., silicon germanium having 70 atomic percent germanium is compositionally different than from silicon germanium having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the material has an element that is not in the other material.

### Architecture

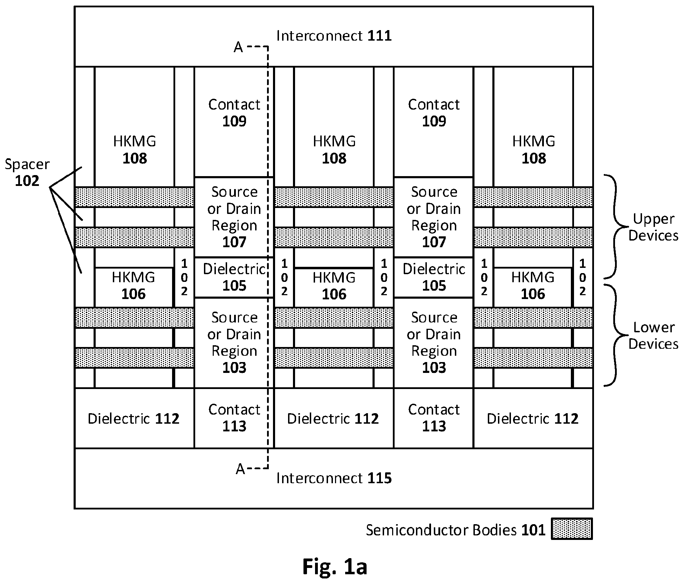

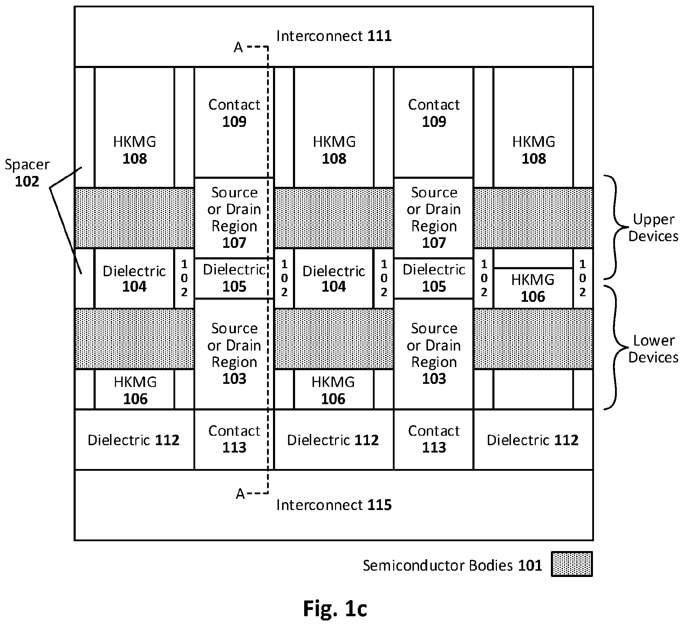

Figures 1a is a cross-sectional side view of an example integrated circuit including stacked transistor architecture configured with wrap-around contacts, in accordance with an embodiment of the present disclosure. The stacked configuration includes upper devices and lower devices, formed on the same fin structure, each device including one or more semiconductor bodies 101 between source and drain regions 103 (lower) and 107 (upper). The fin structure can be formed, for example, from a multilayer substrate that includes alternating layers of etch selective semiconductor materials, such as silicon and silicon germanium (SiGe), although any number of material systems can be used. In one such a case, semiconductor bodies 101 can be formed, for instance, from layers of silicon and the SiGe layers are selectively etched away during gate and source/drain processing. As can be seen, the cross-section is taken parallel to, and through, the fin structure, such that the channel, source, and drain regions are shown. This particular cross-section includes three channel regions along with a source region and a drain region in each of the upper and lower device regions, but any number of channel regions and corresponding source and drain regions can be included, as will be appreciated. Further note that all transistors shown in this example are contacted, but other examples may include dummy devices or devices that are not connected into the overall circuit; likewise, other examples may include a configuration where both top and bottom devices are contacted from the frontside only, or the backside only, or a mix of frontside and backside. The semiconductor bodies 101 included in the channel regions of the upper and lower transistors can vary in form, but in this example embodiment are in the form of nanoribbons. In particular, the channel regions of the lower devices in this example case each include a first set of two nanoribbons 101, and the channel regions of the upper devices each include a second set of two nanoribbons 101 over the corresponding first set. Other examples may include fewer nanoribbons 101 per channel region (e.g., one), or more nanoribbons 101 per channel region (e.g., three or four). Still other embodiments may include other channel configurations, such as a fin (such as shown in Figure 1c) or other semiconductor body. To this end, the present disclosure is not intended to be limited to any particular channel configuration or topology.

With further reference to Figure 1a, the lower device region includes source and drain regions 103 (e.g., source region is on left and drain region is on right, or vice-versa), each adjacent to and in contact with a channel region (nanoribbons 101) on either side. Other embodiments may not have channel regions to each side, such as the example case where only the channel region between the source and drain regions 103 is present. As can be further seen, a high-k metal gate (HKMG) structure 106 is wrapped around the nanoribbons 101, in this example embodiment. Spacer 102 isolates semiconductor gate structure 106 from contacting the source and drain regions 103. In other embodiments, there may be other insulator layers (e.g., interlayer dielectric) that prevent such contact, whether in addition to spacer 102, or in place of spacer 102. In addition, contacts 113 provide backside contact to the source and drain regions 103, and interconnect 115 may provide interconnection between contacts 113 and other parts of the integrated circuit. In addition, or alternatively, contacts 109 may extend down to provide frontside contact to the source and drain regions 103.

The upper device region includes source and drain regions 107 (e.g., source region is on left and drain region is on right, or vice-versa), each adjacent to and in contact with a channel region (nanoribbons 101) on either side. Again, other embodiments may not have channel regions to each side, such as the example case where only the channel region between the source and drain regions 107 is present. As can be further seen, a high-k metal gate (HKMG) structure 108 is wrapped around the nanoribbons 101, in this example embodiment. Spacer 102 isolates semiconductor gate structure 108 from contacting the source and drain regions 103. In addition, contacts 109 provide frontside contact to the source and drain regions 107, and interconnect 111 may provide interconnection between contacts 109 and other parts of the integrated circuit. In addition, or alternatively, contacts 113 may extend up to provide backside contact to source and drain regions 107. Any number of interconnect schemes can be used, as will be appreciated in light of this disclosure.

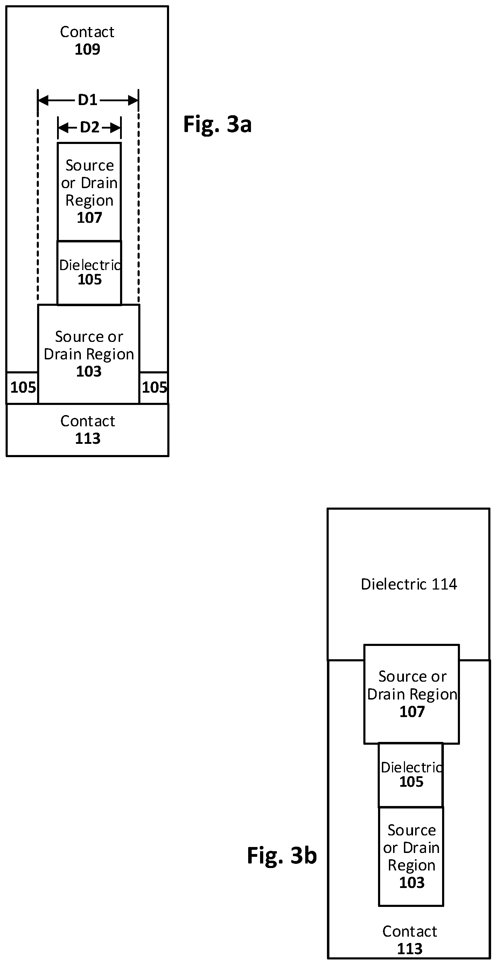

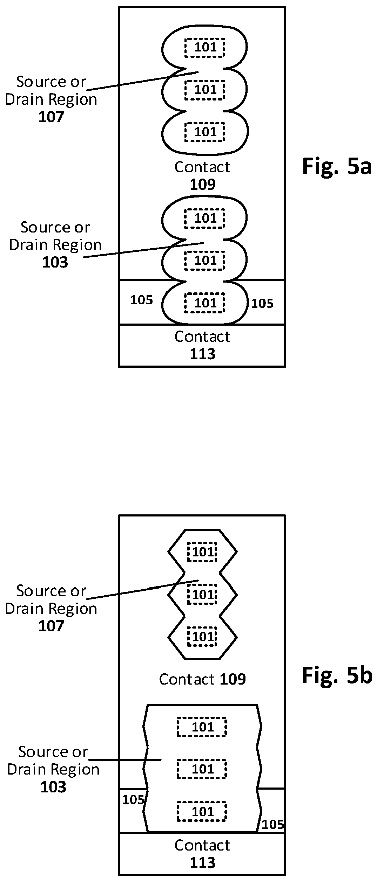

The source or drain regions 103 and 107 may also be referred to as lower and upper diffusion regions, for ease of description. As can further be seen in the example structure of Figure 1a, dielectric layer 105 prevents a lower diffusion region 103 from contacting an upper diffusion region 107, and prevents drain region 103b from contacting drain region 107b. In particular, dielectric layer 105 includes dielectric material, and is on a top surface of each of diffusion region 103. In addition, a bottom surface of each of diffusion region 107 is on a corresponding top surface of dielectric layer 105. Other embodiments may not include dielectric layer 105, such as the example case where that space is occupied by conductive contact material, as will be explained in turn. Recall that that source and drain regions can be asymmetrically shaped, as will be further discussed with reference to the examples of Figures 3a-b and 5a-b. For example, in the case of a frontside vertical interconnect from the top diffusion region 107 to the bottom diffusion region 103, the top diffusion region 107 may be smaller in its span relative to the bottom diffusion region 103, according to some embodiments. Similarly, in the case of a backside vertical interconnect from the bottom diffusion region 103 to the top diffusion region 107, the bottom diffusion region 103 may be smaller in its span relative to the top diffusion region 107, according to some embodiments.

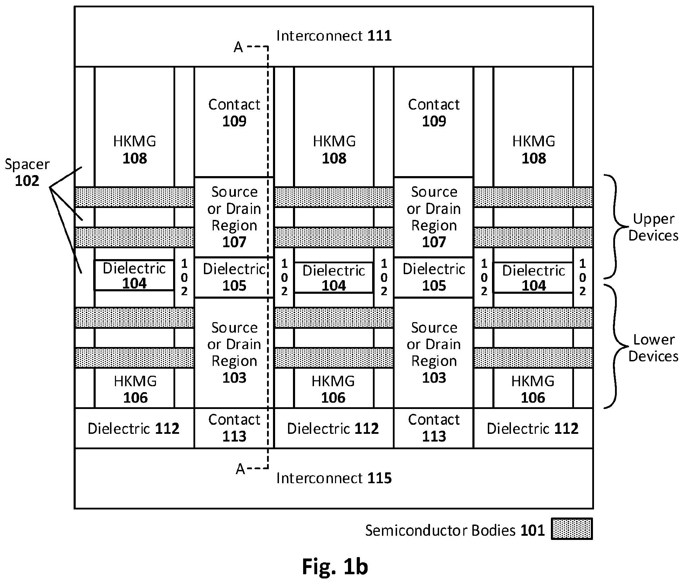

Each of gate structures 106 and 108 can be formed via gate-first or gate-last processing, and may include any number of suitable gate materials and configurations. Note in this example that the lower gate structures 106 and upper gate structures 108 are connected. In other embodiment, at least some of the gate may be separated by a dielectric layer, such as shown in Figures 1b and 1c. In an embodiment, each of the gate structures 106 and 108 includes a gate electrode and a gate dielectric between the gate electrode and the semiconductor bodies 101. Spacer 102 may also be considered part of the gate structures. Spacer 102 may be, for example, silicon nitride or oxynitride or oxycarbonitride. The gate dielectrics of this example includes high-k gate dielectric materials, although any suitable gate dielectric material(s) can be used, such as silicon dioxide. Examples of high-k gate dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some example embodiments, an annealing process may be carried out to improve gate dielectric quality when a high-k material is used. Further, the gate electrodes may comprise a wide range of suitable metals or metal alloys, such as aluminum, tungsten, cobalt, ruthenium, molybdenum, titanium, tantalum, copper, titanium nitride, or tantalum nitride, for example.

In some embodiments, the gate dielectrics and/or gate electrodes may include a multilayer structure of two or more material layers or components. For instance, in one such embodiment, the gate dielectric can be a bi-layer structure having a first dielectric material (e.g., silicon dioxide) in contact with semiconductor bodies 101 and a second high-k dielectric material (e.g., hafnium oxide) in contact with the first dielectric material. Likewise, the gate electrode may include a central metal plug or fill metal portion (e.g., tungsten, cobalt, molybdenum, ruthenium) with one or more outer workfunction layers (e.g., titanium nitride for PMOS workfunction, or an aluminum-containing alloy such as titanium aluminum carbide for NMOS workfunction) and/or barrier layers (e.g., tantalum nitride), and/or a resistance reducing cap layer (e.g., cobalt). In some embodiments, the gate dielectric and/or gate electrode may include concentration grading (increasing or decreasing) of one or more materials therein. Numerous gate structure configurations can be used along with the techniques provided herein, and the present disclosure is not intended to be limited to any particular such configurations.

Likewise, numerous source and drain configurations can be used, and the present disclosure is not intended to be limited to any particular ones. In some example embodiments, the source and drain regions 103 and 107 are epitaxial source and drain regions that are provided after the relevant portion of the fin was isolated and etched away or otherwise removed. In other embodiments, the source/drain regions may be doped portions of the fin or substrate, rather than epi regions. The source and drain regions 103 and 107 can be any suitable semiconductor material and may include any dopant scheme. For instance, source and drain regions 103 may be PMOS source and drain regions that include, for example, group IV semiconductor materials such as silicon, germanium, SiGe, germanium tin (GeSn), SiGe alloyed with carbon (SiGe:C). Example p-type dopants include boron, gallium, indium, and aluminum. Source and drain regions 107 can be NMOS source and drain regions that include, for example, silicon or group III-V semiconductor materials such as two or more of indium, aluminum, arsenic, phosphorus, gallium, and antimony, with some example compounds including but not limited to indium aluminum arsenide, indium arsenide phosphide, indium gallium arsenide, indium gallium arsenide phosphide, gallium antimonide, gallium aluminum antimonide, indium gallium antimonide, or indium gallium phosphide antimonide. In one specific embodiment, source and drain regions 103 are boron-doped SiGe, and source and drain regions 107 are phosphorus-doped silicon. In a more general sense, the source and drain regions 103 and 107 can be any semiconductor material suitable for a given application.

In some cases, source and drain regions 103 and 107 may include a multilayer structure, such as a germanium cap on a SiGe body, or a germanium body and a carbon-containing SiGe spacer or liner between the corresponding channel region and that germanium body. In any such cases, a portion of the epi source and drain regions may have a component that is graded in concentration, such as a graded germanium concentration to facilitate lattice matching, or a graded dopant concentration to facilitate low contact resistance. Any number of source and drain configurations can be used as will be appreciated, and the present disclosure is not intended to be limited to any particular such configurations.

The semiconductor bodies 101, which in this case are nanoribbons, can be any number of semiconductor materials as well, such as group IV material (e.g., silicon, germanium, or SiGe) or group III-V materials (e.g., indium gallium arsenide). In other embodiments, the semiconductor bodies 101 may be fins on which the corresponding gate structures are formed to provide double-gate or tri-gate configurations (as opposed to gate-all-around configurations with nanoribbons or wires), such as shown in Figure 1c. The semiconductor bodies 101 may be doped, partially doped, or undoped, and may be shaped or sculpted during the gate formation process, according to some embodiments. In some cases, semiconductor bodies 101 may be a multilayer structure, such as a SiGe body cladded with germanium, or a silicon body cladded with SiGe. Any number of channel configurations can be used.

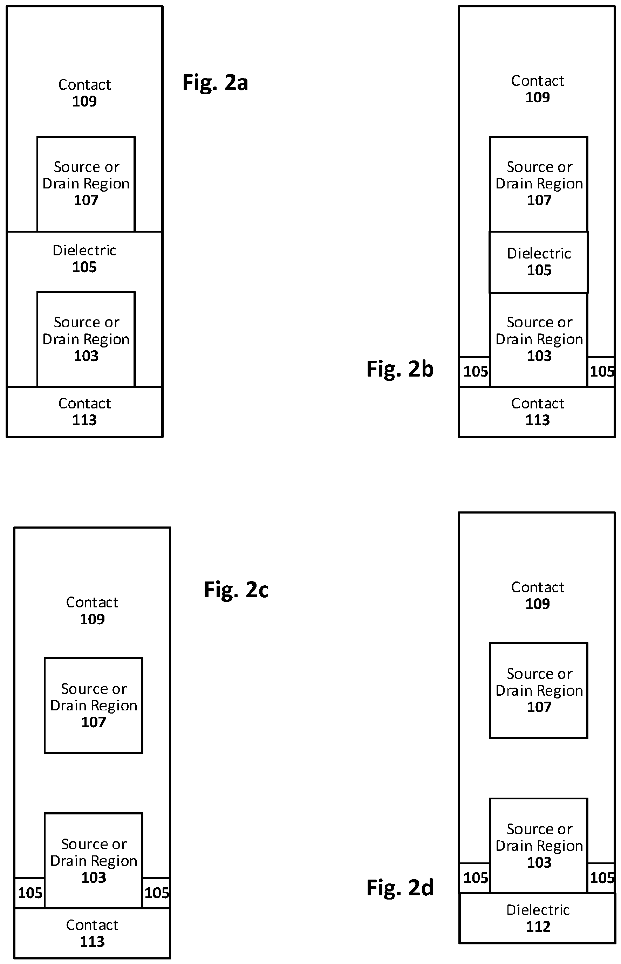

The contacts 109 and 113 can have any number of wrap-around configurations, as will be discussed in further detail with respect to Figures 2a-g, 3a-b, and 4a-g. Note that details of the wrap-around contact are more readily seen in a cross-section view that is orthogonal to the view shown here in Figure 1a. The contacts 109 and 113 include a contact metal, such as metal can be any suitable plug/core material, such as tungsten, ruthenium, molybdenum, cobalt, titanium, titanium silicide, tungsten silicide, cobalt silicide, copper, or alloys thereof. The contacts 109 and 113 may further include a conductive liner or barrier layer, deposited in a contact trench formed over and around the source and drain regions 103 and 107. The liner can be, for example, tantalum or tantalum nitride. In some cases, the contacts 109 and 113 can be optimized p-type and n-type similar to p-type and n-type gate electrodes. For instance, according to some such embodiments, the liner can be titanium for NMOS source/drain contacts, or nickel or platinum for PMOS source/drain contacts. In still other embodiments, the contacts 109 and 113 may include resistance reducing materials (e.g., nickel, platinum, nickel platinum, cobalt, titanium, germanium, nickel, gold, or alloys thereof such as germanium-gold alloy, or a multilayer structure of titanium and titanium nitride all have good contact resistance), in addition to contact metal and any liner. Other embodiments may be configured differently. Further note that contacts 113 can be formed in a dielectric layer 112, during a backside contact process that includes removing backside substrate material (e.g., silicon); in other embodiments, contacts 113 may be formed in the backside substrate material (e.g., where contacts 113 are formed in silicon sub-fin layer 112). In any such cases, one or both of contacts 109 and 113 can be formed as a wrap-around contact in accordance with an embodiment of the present disclosure. Note that the relative position and geometry of 103/112/113 can vary depending on the forming process, and they need not be limited to the particular example structure shown. In some embodiments, for instance, layer 112 is semiconductor material of the sub-fin (rather than dielectric material), and diffusion regions 103 can extend downward and into layer 112, with epitaxial growth of diffusion regions 103 on sidewalls of the trench extending into layer 112.

Interconnects 111 and 115 can also have many configurations, but generally include one or more dielectric layers (e.g., silicon dioxide) having conductive features (e.g., copper or aluminum vias, conductive runs, etc.) formed therein.

Figure 1b is a cross-sectional view that illustrates another example integrated circuit configured with wrap-around contacts, in accordance with some embodiments of the present disclosure. As can be seen, this example is similar to the example of Figure 1a, except that dielectric layer 104 is used to separate the lower gate structures 106 from the upper gate structures 108. The previous relevant discussion is equally applicable here. Thus, while the lower and upper diffusion regions 103 and 107 of a given device may be connected by virtue of a wrap-around contact, the lower gate structures 106 and the upper gate structures 108 need not also be connected to one another.

Figure 1c is a cross-sectional view that illustrates another example integrated circuit configured with wrap-around contacts, in accordance with some embodiments of the present disclosure. As can be seen, this example is similar to the example of Figure 1a, except that semiconductor bodies 101 are fins rather that nanoribbons, and dielectric layer 104 is used to separate the two leftmost lower gate structures 106 from the two leftmost upper gate structures 108; and the rightmost lower gate structure 106 is connected to the upper gate structure 108. Other differences and variations between Figures 1a and 3a will be discussed in turn. The previous relevant discussion is equally applicable here. Note the gate structures 106 and 108 can be tri-gate (or double-gate) structures that are on top and side surfaces of the fins 101, rather than be gate-all-around structures like in Figures 1a-b. Further note that other embodiments may have the rightmost lower gate structure 106 isolated from the upper gate structure 108 with dielectric 104; alternatively, the two leftmost lower gate structures 106 may be in contract with the two leftmost upper gate structures 108. In a more general sense, any number of transistor circuits can be formed, as will be appreciated.

Figures 2a-2g are cross-sectional side views of example wrap-around contacts that extend down both sides of a source or drain region in a stacked transistor architecture, in accordance with some embodiments of the present disclosure. Note these cross-sections are orthogonal to the cross-sections of Figures 1a-c, and taken through the dashed line marked A-A. The example of Figure 2a shows that frontside wrap-around contact 109 is on top and side surfaces of source or drain region 107, and sits on top of dielectric layer 105. As can be further seen, backside contact 113 is not a wrap-around contact in that it is only on the bottom of source or drain region 103, and also abuts dielectric layer 105.

Figure 2b shows another example where a frontside wrap-around contact 109 is on top and side surfaces of source or drain region 107 and also extends down along side surfaces of source or drain region 103, and sits on top of dielectric layer 105. As can be further seen, backside contact 113 is not a wrap-around contact in that it is only on the bottom of source or drain region 103, and also abuts dielectric layer 105. Further note that dielectric 105 remains between source or drain region 107 and source or drain region 103 in this example. The example of Figure 2c is similar to that of Figure 2b, except that there is no dielectric 105 between source or drain region 107 and source or drain region 103. Instead, that space is filled with conductive material of wrap-around contact 109. In still other embodiments that space can be occupied by etch stop material, or other dielectric material that can be selectively etched with respect to dielectric 105. The example of Figure 2d is similar to that of Figure 2c, except that there is no backside contact 113. Instead, that space is filled with dielectric 112.

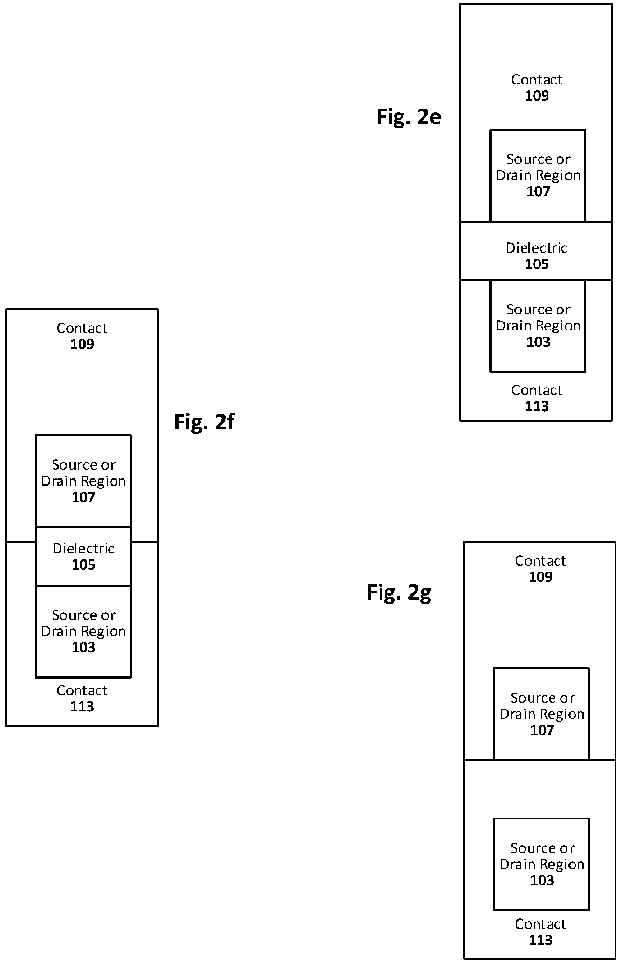

Figure 2e shows another example where a frontside wrap-around contact 109 is on top and side surfaces of source or drain region 107 and sits on top of dielectric layer 105, and a backside wrap-around contact 113 is on bottom and side surfaces of source or drain region 103 and abuts the bottom of dielectric layer 105. Further note that dielectric 105 remains between contact 109 and contact 113, as well as source or drain region 103 and source or drain region 107 in this example. The example of Figure 2f is similar to that of Figure 2e, except that there is no dielectric 105 contact 109 and contact 113. Instead, contact 109 and contact 113 are in contact with one another. The example of Figure 2g is similar to that of Figure 2f, except that there is no dielectric 105 between source or drain region 107 and source or drain region 103. Instead, that space is filled with conductive material of contact 113.

Figures 3a-3b are cross-sectional side views of example wrap-around contacts on asymmetrically sized source or drain regions in a stacked transistor architecture, in accordance with some embodiments of the present disclosure. Again, note these cross-sections are orthogonal to the cross-sections of Figures 1a-c, and taken through the dashed line marked A-A. Figure 3a shows an example where a frontside wrap-around contact 109 is on top and side surfaces of source or drain region 107 and also extends down along side surfaces of source or drain region 103, and sits on top of dielectric layer 105. As can be further seen, backside contact 113 is not a wrap-around contact in that it is only on the bottom of source or drain region 103, and also abuts dielectric layer 105. In other such examples, backside contact 113 may not be present (e.g., it may just be dielectric material there). Further note that dielectric 105 remains between source or drain region 107 and source or drain region 103 in this example; in other examples it may be removed so that space may be filled with conductive material of contact 109. Further note that the epitaxial span of source or drain region 103 is a distance D1, and the epitaxial span of source or drain region 107 is a smaller distance D2. Such an asymmetrical arrangement can be helpful for a frontside wrap-around contact.

A similar but opposite asymmetrical arrangement is shown in Figure 3b, which is helpful for a backside wrap-around contact. In particular, Figure 3b shows an example where a backside wrap-around contact 113 is on bottom and side surfaces of source or drain region 103 and also extends up along side surfaces of source or drain region 107, and abuts a bottom of dielectric layer 114. One helpful aspect of such asymmetrical source or drain arrangements is that they can improve (lower) the height-to-width aspect ratio of the etch path when removing dielectric fill materials prior to deposition of the conductive contact materials. The difference between distances D1 and D2 can vary from one embodiment to the next, but in some example cases distance D1 is in the range of 5 nanometers (nm) to 25 nm larger than distance D2, or distance D1 is in the range of 10% to 50% larger than distance D2. The difference between D1 and D2 can be achieved, for example, through timing of the epitaxial deposition. The longer the deposition, the larger the epitaxial span of the deposited material. So, the epitaxial deposition to provide source and drain regions having a span of D1 runs longer than the epitaxial deposition to provide source and drain regions having a span of D2.

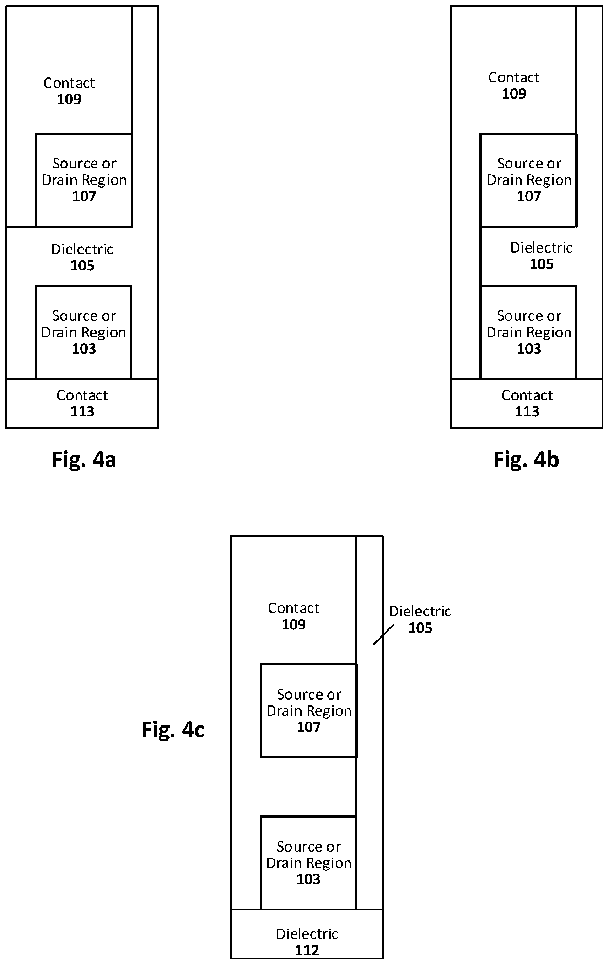

Figures 4a-4g are cross-sectional side views of example wrap-around contacts that extend down one side of a source or drain region in a stacked transistor architecture, in accordance with some embodiments of the present disclosure. Again, note these cross-sections are orthogonal to the cross-sections of Figures 1a-c, and taken through the dashed line marked A-A. Figure 4a shows an example where a frontside wrap-around contact 109 is on top and left-side surfaces of source or drain region 107 and sits on top of dielectric layer 105. As can be further seen, backside contact 113 is not a wrap-around contact in that it is only on the bottom of source or drain region 103, and source or drain region 103 effectively sits within dielectric layer 105. Further note in this example that dielectric 105 remains between source or drain region 107 and source or drain region 103, and extends up along the right-side surfaces of source or drain region 107 and contact 109. The example of Figure 4b is similar to that of Figure 4a, except that frontside wrap-around contact 109 further extends down left-side surfaces of dielectric 105 and source or drain region 107 and sits on top of backside contact 113. The example of Figure 4c is similar to that of Figure 4b, except there is no dielectric 105 between source or drain region 107 and source or drain region 103. Instead, that space is filled with conductive material of wrap-around contact 109.

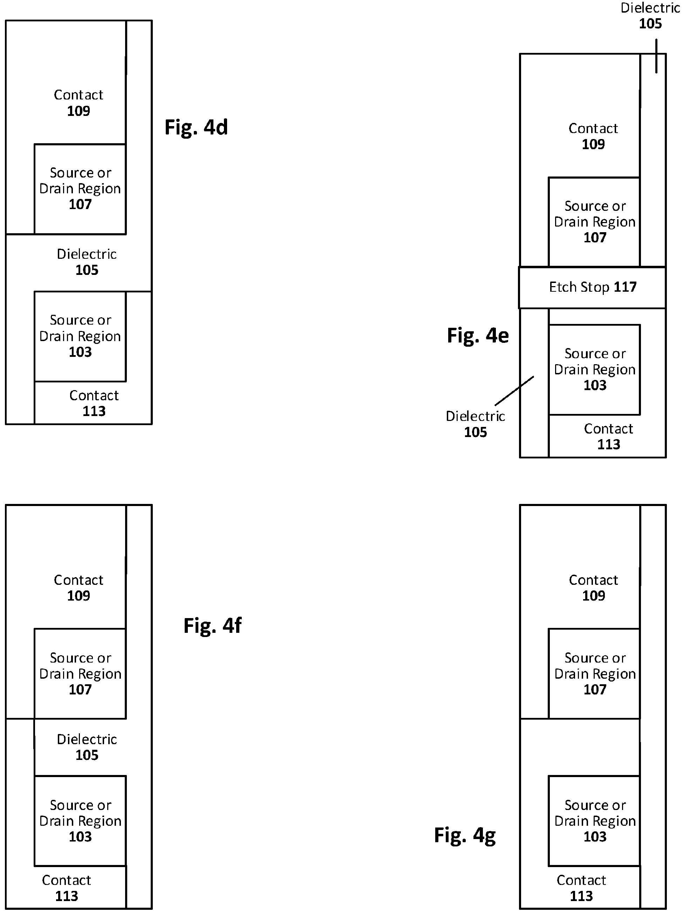

Figure 4d shows an example where a frontside wrap-around contact 109 is on top and left-side surfaces of source or drain region 107 and sits on top of dielectric layer 105. As can be further seen, backside contact 113 is on bottom and right-side surfaces of source or drain region 103. Further note in this example that dielectric 105 remains between source or drain region 107 and source or drain region 103, and extends both (1) up along the right-side surfaces of source or drain region 107 and contact 109, and (2) down along the left-side surfaces of source or drain region 103 and contact 113.

Figure 4e shows an example where source or drain region 103 and source or drain region 107 are separated by an etch stop 117. In addition, a frontside wrap-around contact 109 is on top and left-side surfaces of source or drain region 107 and sits on top of etch stop 117. As can be further seen, backside contact 113 is on top, bottom and right-side surfaces of source or drain region 103. Further note in this example that dielectric 105 extends up along the right-side surfaces of source or drain region 107 and contact 109, and down along the left-side surfaces of source or drain region 103 and contact 113.

Figure 4f shows an example where a frontside wrap-around contact 109 is on top and left-side surfaces of source or drain region 107. As can be further seen, backside contact 113 is on bottom and left-side surfaces of source or drain region 103, and extends up and abuts contact 109. Further note in this example that dielectric 105 remains between source or drain region 107 and source or drain region 103, and extends both (1) up along the right-side surfaces of source or drain region 107 and contact 109, and (2) down along the right-side surfaces of source or drain region 103 and contact 113.

Figure 4g shows an example where a frontside wrap-around contact 109 is on top and left-side surfaces of source or drain region 107. As can be further seen, backside contact 113 is on top, bottom and left-side surfaces of source or drain region 103, and extends up and abuts contact 109. Further note in this example that there is no dielectric 105; instead that space is occupied by conductive material of backside contact 113. Dielectric 105 extends both up along the right-side surfaces of source or drain region 107 and contact 109, and down along the right-side surfaces of source or drain region 103 and contact 113.

Figures 5a-5b are cross-sectional side views of example wrap-around contacts on top and side surfaces of variously shaped source or drain regions in a stacked transistor architecture, in accordance with some embodiments of the present disclosure. As can be seen in Figure 5a, a frontside contact 109 is on top, bottom and side surfaces of source or drain region 107, as well as top and side surfaces of source or drain region 103. Each of the diffusion regions 103 and 107 has been epitaxially grown from the ends of nanoribbons 101 of the channel region, which are exposed when the source drain recess is formed. The nanoribbons 101 are shown in dashed outline, as they may not actually appear in the cross-section. As can be further seen, the epitaxial growth of each of the nanoribbons in the upper device region has merged to form a single upper epitaxial region with wavy sidewalls; likewise, the epitaxial growth of each of the nanoribbons in the lower device region has merged to form a single lower epitaxial region with wavy sidewalls. Note that the contact can conform to the wavy sidewalls.

The example of Figure 5b is similar to that of Figure 5a, except that the epitaxial source or drain regions are more faceted, and are also asymmetrical with respect to their lateral spans. Specifically, the upper source or drain region 107 was grown to be smaller relative to the lower source or drain region 103, which may have grown in a constrained matter due to, for example, sidewalls of the source/drain recess in which the source or drain region 103 was grown. As previously explained above, such an asymmetrical arrangement can be helpful for a frontside wrap-around contact that extends down to the lower source or drain region, or a backside wrap-around contact that extends up to the upper source or drain region, according to some embodiments.

Further note, in either of the examples of Figures 5a-b, that backside contact 113 may or may not be present, given that frontside contact is on top and side surfaces of source or drain regions 103.

### Methodology

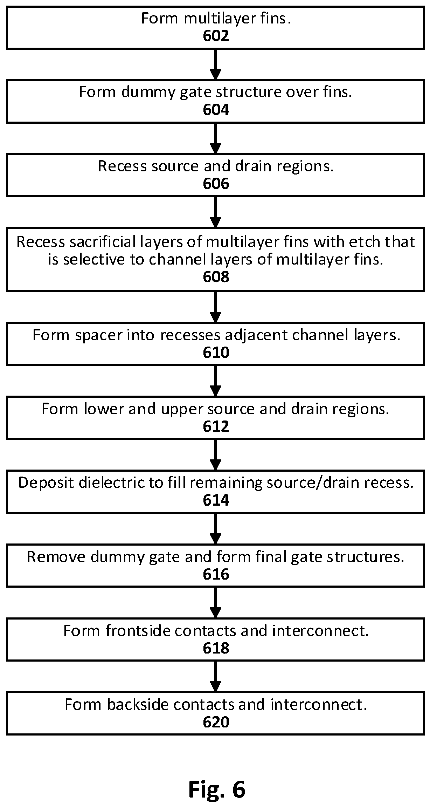

Figure 6 is a flowchart of a fabrication process for an integrated circuit including stacked transistor architecture configured with wrap-around contacts, in accordance with an embodiment of the present disclosure. This method can be used, for instance, to form the example structures shown in Figures 1a-c, 2a-g, 3a-b, 4a-g, and 5a-b, although other structures will be apparent in light of this disclosure. The method includes forming 602 a number of multilayer fins, which can be accomplished, for instance, by patterning a multilayer substrate and etching it to form multilayer fins. Multilayer fins are particularly useful when forming nanoribbon devices or other gate-all-around devices. Other embodiments may include single layer fins to provide devices having tri-gate or other fin-based channel regions. The method continues with forming 604 a number of dummy gate structures over the fins. Standard dummy gate processing can be used. Note that in some cases, the dummy gate structure(s) may include a gate spacer that also deposits on sidewalls of the multilayer fin(s), and that gate spacer can be used to constrain epitaxial growth of diffusion regions (at 612). The method continues with recessing 606 the source and drain regions (also referred to herein as diffusion regions), to each side of a given gate structure. Standard lithography masking and etching can be used to form the source/drain recesses.

The method continues with laterally recessing 608 sacrificial layers (layers adjacent to the layers used to form semiconductor bodies 101) of the multilayer fin with etch that is selective to channel layers of the multilayer fin. In one example case where the multilayer fin includes alternating layers of silicon and SiGe, an etch that is selective to the silicon layer is used to recess the SiGe layers. The depth of the recess can vary from one embodiment to the next, but in some cases is in the range of 2 to 10 nm. In an embodiment, the recess is carried out via an isotropic wet etch. The method continues with forming 610 spacer material into the recesses, so as to provide spacer material between channel layers of the multilayer fin. Note this spacer material can be, for example, the same spacer material (e.g., a nitride, such as silicon nitride, silicon oxy nitride, or silicon oxycarbonitride) as the gate spacer used when forming the dummy gate structure at 604. A conformal deposition process can be used to deposit the spacer, such as chemical vapor deposition (CVD) or ALD.

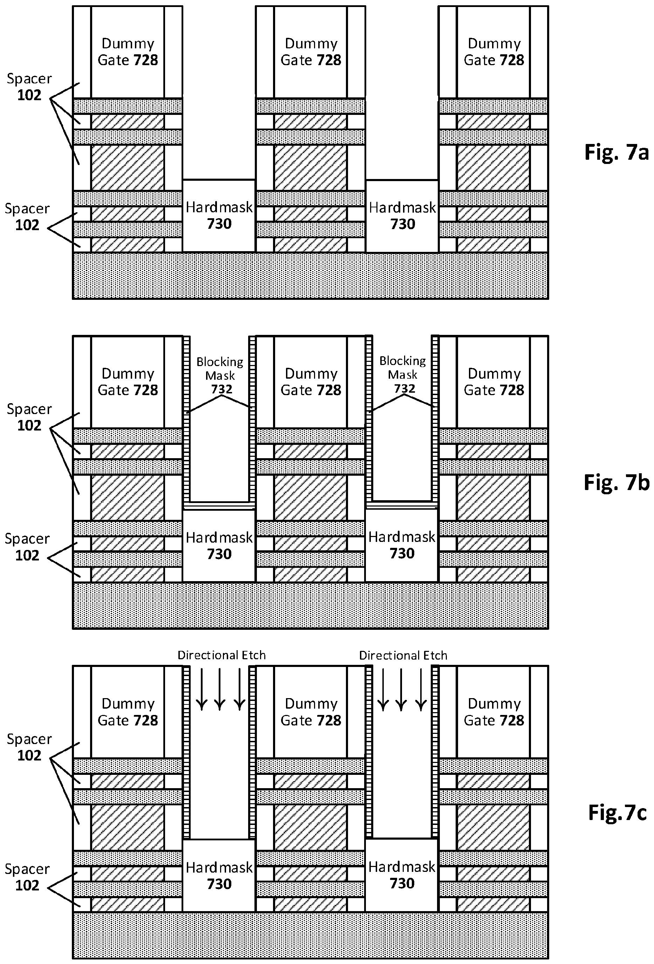

The method continues with forming 612 the lower and upper source and drain regions. Such forming can be accomplished, for instance, by way of selective epitaxial deposition and etch-back processes where needed. Blocking masks may also be used to increase selectivity of deposition, as will be further discussed with reference to Figures 7a-j. Further recall that the source and drain regions may be grown in an asymmetrical fashion (where upper diffusion region has a smaller lateral span than the lower diffusion region to accommodate a frontside wrap-around contact, or vice-versa to accommodate a backside wrap-around contact). The method continues depositing 614 dielectric (e.g., oxide, such as silicon dioxide) to fill any remaining portion of the source and drain recesses. In some cases, an etch stop may be deposited between the upper and lower diffusion regions, prior to deposition of a recess fill oxide. In one such example case, a conformal layer or bi-layer of etch stop material(s) (e.g., nitride, carbide, and/or other material that is etch selective with respect to the recess fill material (e.g., silicon dioxide) is deposited via ALD until the space between the upper and lower diffusion regions closes off (and thus blocks any subsequent deposition of oxide fill. Such an etch stop can be useful, for instance, in cases where it is desirable to not have the fill oxide between the between the upper and lower diffusion regions (such as shown in the examples of Figures 2c-d, 2g, 4c, 4g, and 5a-b). This is because the oxide fill material can be removed with an anisotropic (directional) etch that is selective to etch stop material(s), and the etch stop can be removed with an isotropic etch that is selective to the oxide fill material. Chemical mechanical polish (CMP) processing can be used to planarize the resulting structure and remove extraneous materials from the top of the structure.

The method continues with removing 616 the dummy gate structure(s) and forming the final gate structures. So, for instance, polysilicon dummy gate material can be removed from between silicon nitride gate spacers to expose the underlying channel region. At this point, some embodiments may include releasing a number of nanoribbons or other semiconductor bodies within the exposed channel region, by we of a selective etch. Channel shaping and depopulation (e.g., removal of one or more nanowires or ribbons) may also be carried out. In any case, the final gate structures may include standard features of a gate structure (e.g., high-k gate dielectric such a hafnium oxide, workfunction layers such as titanium nitride for p-type gates or titanium aluminum carbide for n-type gates, and gate fill metal such as tungsten, molybdenum, or ruthenium). Note that the bottom gate structures can be formed first, but those bottom gate materials will also deposit on the upper channel regions. So, the that gate material on the upper channel regions can be recessed or otherwise removed, and then the upper gate structures can be formed.

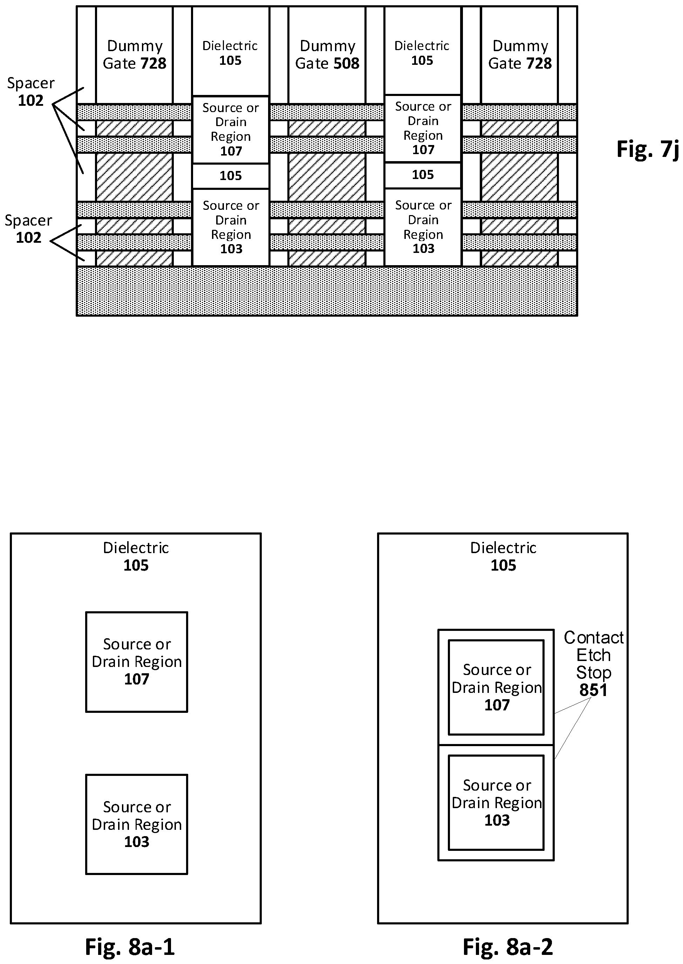

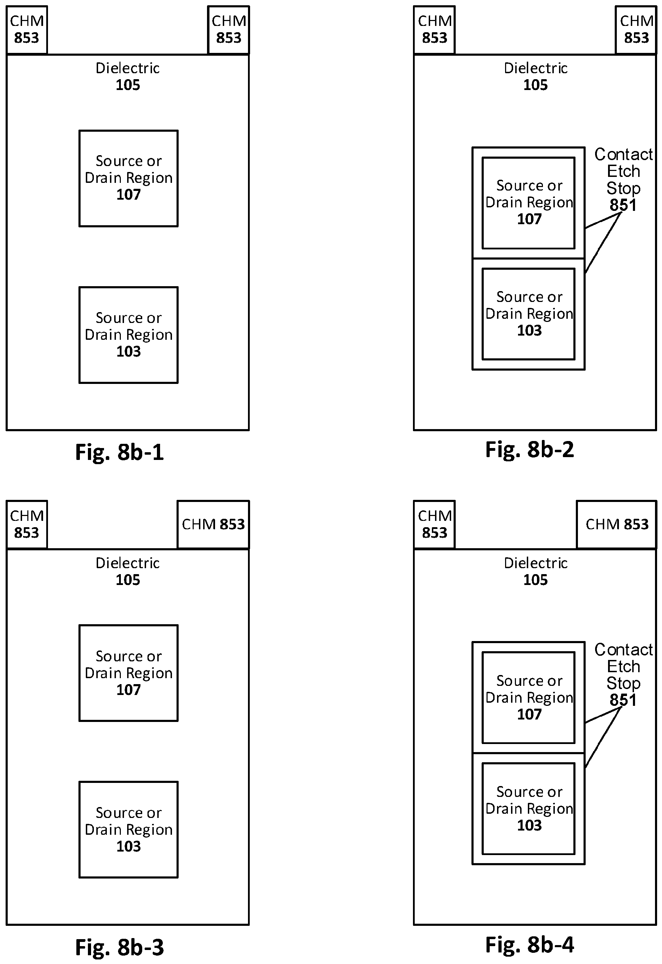

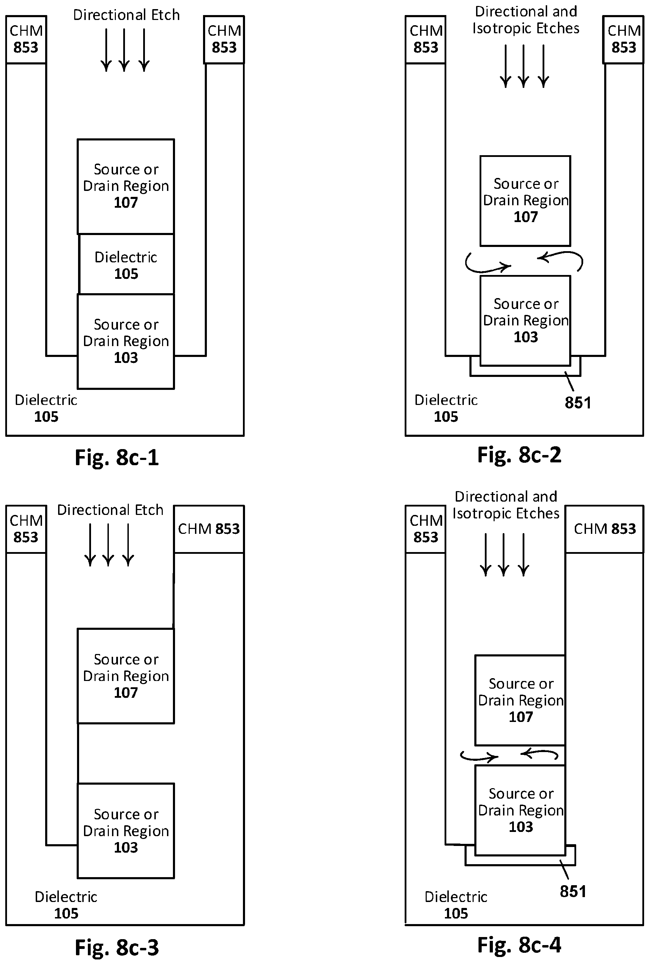

The method continues with forming 618 frontside contacts and interconnect, and forming 620 backside contacts and interconnect. Any number of frontside and/or backside contacts can be used, such as those shown in Figures 2a through 5b. Further example details and embodiments with respect to forming such wrap-around contacts will be discussed in turn with respect to Figures 8a-1 through 9c-4.

Figure 7a-j are cross-sectional side views that collectively illustrate an example process for forming source and drain regions in an integrated circuit including stacked transistor architecture configured with wrap-around contacts, in accordance with an embodiment of the present disclosure. This process can be used, for instance, at 612 of the method shown in Figure 6. As can be seen, the cross-sections are taken parallel to, and through, the fin structure. As can be seen, dummy gate structures 728 have been formed over respective channel regions (at 604), and the semiconductor bodies (nanoribbons in this example) in the channel region have not yet been released (sacrificial material indicated with slanted cross-hatching is still intact, but will be selectively etched away during subsequent gate processing at 616). In addition, the recesses for the source and drain regions have been formed (at 606) and the gate spacers 102 have been formed (at 608 and 610).

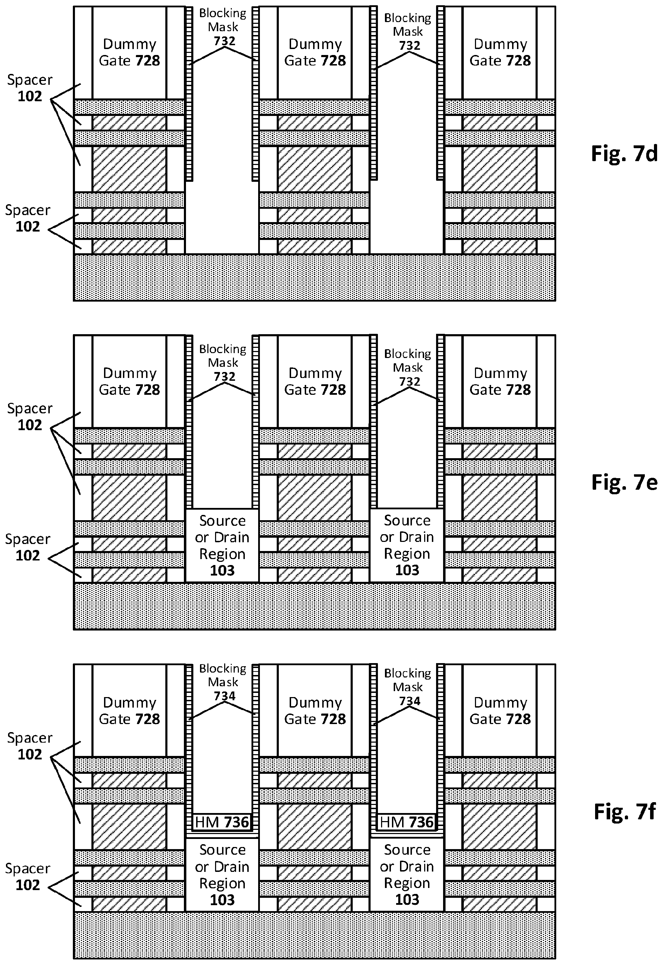

At this point, the process according to some embodiments includes patterning a blocking mask in upper portion of source and drain recesses (adjacent dummy gate and upper channel region). This can be accomplished, for example, as shown in the example of Figures 7a-d. In particular, Figure 7a shows the structure after a hardmask 730 has been formed in the recesses. The hardmask 730 can be, for instance, a carbon hardmask that is deposited into the trench and then etched back to a desired height. Then, as shown in Figure 7b, a blocking mask 732 is conformally deposited (e.g., via CVD or ALD) into the recess. The blocking mask 732 can be, for instance, an oxide or other material upon which epitaxial source/drain material will not grow. The thickness of mask 732 can vary from one embodiment to the next, but in some examples is in the range of 0.5 nm to 5 nm. A directional etch (e.g., anisotropic dry etch) is used to remove mask 732 from horizontal surfaces on which it has deposited, including the top surface of the hardmask 730, as shown in Figure 7c. Then, as shown in Figure 7d, the hardmask 730 is removed. Any standard mask removal process can be used (e.g., ash-based etch). So, with the blocking mask 732 in the upper portion of the recess, the process continues with epitaxially depositing the lower source and drain regions 103. Note that the epitaxial deposition will not deposit on blocking mask 732, and only grows on the exposed semiconductor bodies 101 in the bottom channel region. The resulting structure is shown in Figure 7e. Recall that, for backside wrap-around contacts, the lower source and drain regions 103 may be grown to be smaller (in the lateral direction, in and out of page in this cross-section) than the upper source and drain regions 107, so the epitaxial growth can be timed accordingly. The process continues with removing the blocking mask 732 (e.g., isotropic etch).

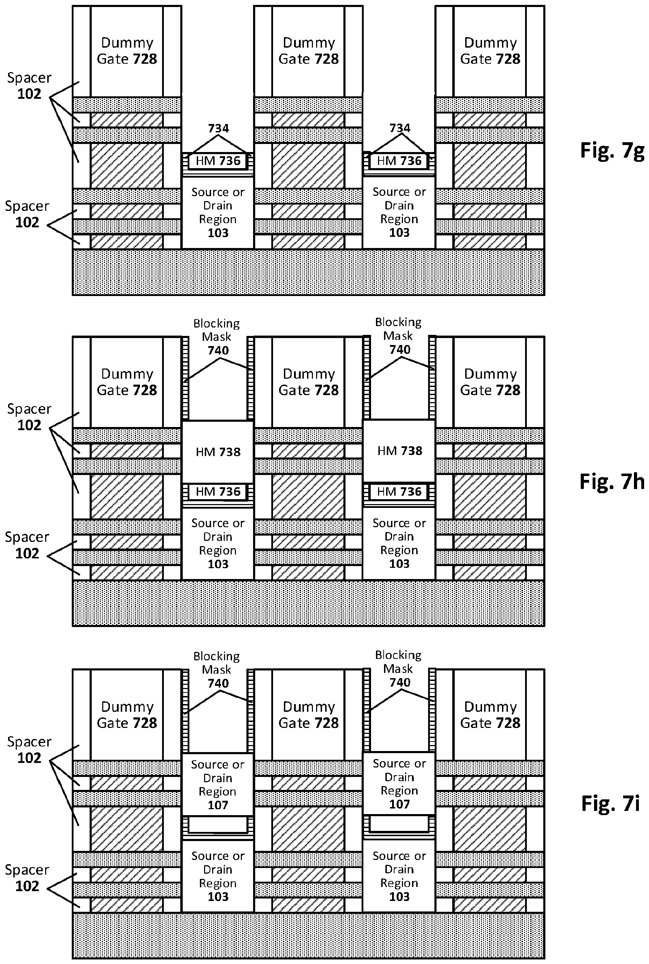

The process continues with patterning a blocking mask on top of the now formed lower source and drain regions. An example such process is shown in Figure 7f-g. As can be seen in Figure 7f, a blocking mask 734 is conformally deposited into the recess. Then, a hardmask 736 is deposited onto mask 734 and recessed to a desired height, as further shown in Figure 7f. Note that this height corresponds to the height of the spacing between the lower 103 and upper 107 diffusion areas. Further note that the height of that spacing can be adjusted to provide a desired degree of vertical asymmetry between the lower 103 and upper 107 diffusion areas, which may be in addition to lateral asymmetry. Further recall that this space may be subsequently filled with dielectric material (e.g., 105) or conductive contact material (e.g., 109 and/or 113) or an etch stop (e.g., 117), according to some example embodiments. The excess (unmasked) portion of blocking mask 734 is then removed, as shown in Figure 7g. Note that blocking mask 734 can be similar to blocking mask 732, and hardmask 736 can be similar to hardmask 730, and the previous relevant discussion with respect to those masks is equally appliable here.

The process continues with patterning another blocking mask on the upper portion of source and drain recesses (adjacent dummy gate), as shown in Figure 7h. In particular, a hardmask 738 is formed on the earlier formed masking structure and then recessed to the appropriate height (e.g., to desired height of upper diffusion region). Then, blocking mask 740 is conformally deposited into the recess, and directionally etched, to provide the resulting structure shown in Figure 7h. The hardmask 738 is then removed. Again, blocking mask 740 can be similar to blocking mask 732, and hardmask 738 can be similar to hardmask 730, and the previous relevant discussion with respect to those masks is equally appliable here. With the uppermost portion of the recess blocked, the process continues with epitaxially depositing the upper source and drain regions 107, as shown in Figure 7i. Recall that the epitaxial growth only occurs on the exposed semiconductor layers 101 (thus, in some embodiments, mask 740 may be skipped, if the epitaxial growth won't grow on spacer 102). Further recall that, for frontside wrap-around contacts, the upper source and drain regions 107 may be grown to be smaller than the lower source and drain regions 103, so the epitaxial deposition can be timed accordingly. With the upper source and drain regions formed, the process continues with removing the blocking masks 734 and 740, as well as any remaining hardmask 736. A dielectric fill material 105 can then be deposited (at 614). CMP can be used to remove excess materials and planarize the resulting structure, thereby providing the structure in Figure 7j.

Figures 8a-1 to 8d-4 and 9a-1 to 9c-4 are cross-sectional side views that collectively illustrate example processes for forming wrap-around contacts in an integrated circuit including stacked transistor architecture, in accordance with some embodiments of the present disclosure. These processes can be used, for instance, at 618 and 620 of the method shown in Figure 6, when forming frontside and backside contacts. As can be seen, the cross-sections are taken parallel to the gate structure, and through the source or drain region, so as to show further details of the contact scheme.

As can be seen in Figures 8a-1 and 8a-2, the earlier-formed source or drain region is encased in dielectric material 105 (e.g., silicon dioxide). Figure 8a-1 shows an example where dielectric material is allowed to deposit between the lower and upper diffusion regions 103 and 107, according to some embodiments. Figure 8a-2 shows an example where a conformal contact etch stop structure 851 (e.g., silicon nitride, or aluminum oxide) is conformally deposited on the lower and upper diffusion regions 103 and 107 so as to effectively fill the space between the lower and upper diffusion regions 103 and 107, thereby preventing are the dielectric material from depositing there, according to some embodiments. In other embodiments, there may be an etch stop layer (e.g., materials similar to 851) that extends laterally between the lower and upper diffusion regions 103 and 107. In such a case, the dielectric fill process at 614 may include, for instance, (1) at least partially filling the recess with dielectric material, (2) recessing the dielectric fill material to an appropriate level between the lower and upper diffusion regions 103 and 107, (3) depositing the etch stop layer, and (4) filling the remainder of the recess with dielectric fill material.

As can be seen in Figures 8b-1 through 8b-4, a mask 853 can be patterned for selectively etching the dielectric 105 to expose the upper diffusion region 107 and possibly the lower diffusion region 103, depending on how deep the etch is allowed to go. The mask 853 can be, for example, a carbon hardmask or photoresist. In Figures 8b-1 and 8b-2, the mask 853 is configured to allow for dielectric material 105 on both the left and rights sides of the diffusion region(s) to be removed via a directional (anisotropic) etch, while Figures 8b-3 and 8b-4, the mask 853 is configured to allow for dielectric material 105 on only on the left side of the diffusion region(s) to be removed via a anisotropic etch. Other embodiments may use a mask configured to allow for dielectric material 105 on only on the right side of the diffusion region(s) to be removed via a anisotropic etch, as will be appreciated.

As can be seen in Figures 8c-1 through 8c-4, dielectric material 105 has been removed via a directional etch (designated with straight arrows). Figures 8c-1 and 8c-2 show examples where the directional etch removes dielectric material 105 on both sides of the upper and lower diffusion regions 107 and 103. Figures 8c-3 and 8c-4 show examples where the directional etch removes dielectric material 105 on left-side surfaces of the upper and lower diffusion regions 107 and 103. In Figures 8c-1 and 8c-3, note how the shadow effect of the upper diffusion region 107 effectively masks the body of dielectric material directly between the upper and lower diffusion regions 107 and 103, given the nature of a directional etch (thus, the top surface of diffusion region 103 and the bottom surface of diffusion region 107 remain covered with dielectric 105). In addition, as shown in Figures 8c-2 and 8c-4, contact etch stop structure 851 has been removed via an isotropic etch (designated with curvilinear arrows). Note that the directional etch to remove the dielectric 105 (e.g., silicon dioxide) is selective to the material(s) of the etch stop structure 851 (e.g., silicon nitride); likewise, the isotropic etch to remove the etch stop structure 851 is selective to dielectric 105. As such, some portion of etch stop structure 851 that is blocked by dielectric 105 may be left intact, as shown on the bottom of diffusion region 103 in Figures 8c-2 and 8c-4. Further note that the depth of the directional etch can be timed or monitored, so as to expose side surfaces of both the upper diffusion region 107 and the lower diffusion region 103 (e.g., such as shown in Figures 2b-d, 3a, 4b-c, 5a-b), or just side surfaces of both the upper diffusion region 107 (e.g., such as shown 2a, 2e, 2g, 4a, and 4d-g). In still other examples, the directional etch may stop in between diffusion regions 103 and 107 (e.g., Figure 2f), or on an etch stop layer (e.g., Figure 4e).

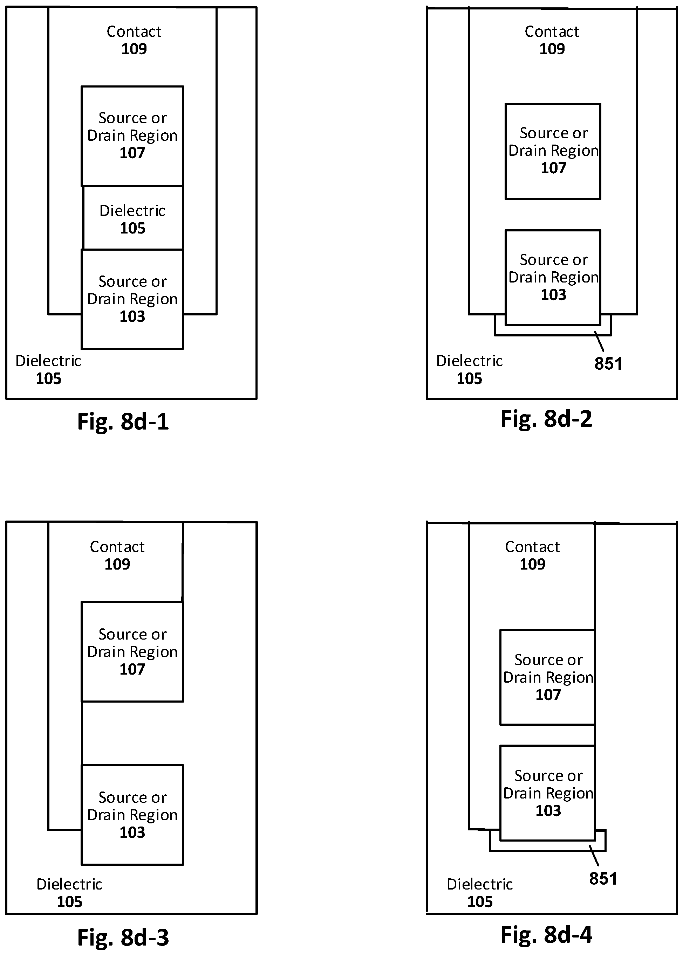

As can be seen in Figures 8d-1 through 8d-4, a frontside wrap-around contact 109 has been formed. In Figure 8d-1, the wrap-around contact 109 is on top and side surfaces of the upper diffusion region 107, as well as along side surfaces of the lower diffusion region 103. The example of Figure 8d-2 is similar to that of Figure 8d-1, except that the frontside wrap-around contact 109 also fills the space between the lower and upper diffusion regions 103 and 107, and is thus on the bottom of diffusion region 107 and the top of diffusion region 103. In Figure 8d-3, the wrap-around contact 109 is on top and left-side surfaces of the upper diffusion region 107 and the lower diffusion region 103. The example of Figure 8d-4 is similar to that of Figure 8d-3, except that the frontside wrap-around contact 109 also fills the space between the lower and upper diffusion regions 103 and 107, and is thus on the bottom of diffusion region 107 and the top of diffusion region 103. Note the remnant of the contact etch stop 851 at the bottom of diffusion region 103 in Figures 8d-2 and 8d-4. Further note that some or all of this remnant 851 may be removed in a backside process, but other embodiments may leave this remnant intact (e.g., because there is no backside contact).

As can be seen in Figures 9a-1 through 9a-4, the structure has been flipped to provide better access to the backside, and a mask 954 has been patterned for selectively etching the dielectric 105 to expose the lower diffusion region 103 and possibly the upper diffusion region 107, depending on how deep the etch is allowed to go. The mask 954 can be, for example, a carbon hardmask or photoresist (e.g., similar to mask 853). In Figures 9b-1 and 9b-2, the mask 954 is configured to allow for dielectric material 105 on both the left and rights sides of the diffusion region(s) to be removed via a directional (anisotropic) etch, while Figures 9b-3 and 9b-4, the mask is configured to allow for dielectric material 105 on only on the right side of the diffusion region(s) to be removed via a anisotropic etch. Other embodiments may use a mask configured to allow for dielectric material 105 on only on the left side of the diffusion region(s) to be removed via a anisotropic etch.

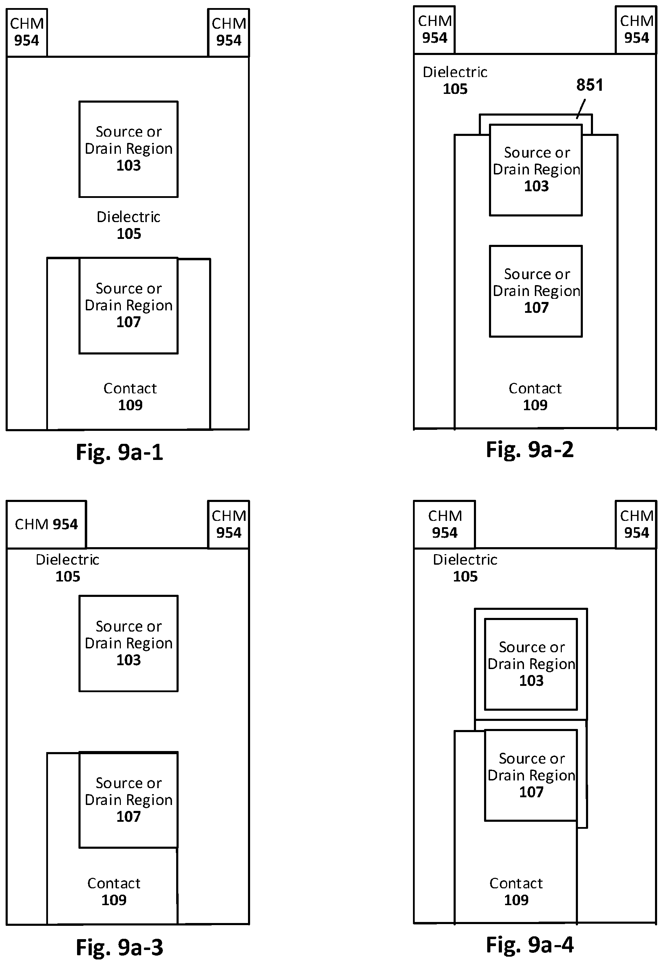

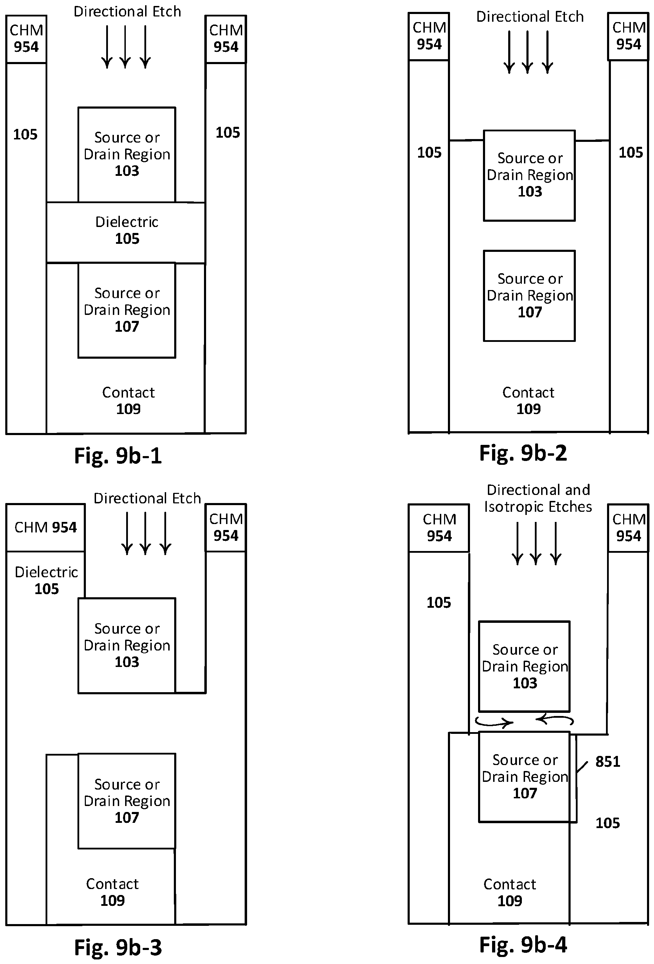

As can be seen in Figures 9b-1 through 9b-4, dielectric material 105 has been removed via a directional etch (designated with straight arrows). Figure 9b-1 shows an example where the directional etch removes dielectric material 105 on both sides of diffusion region 103 and stops on dielectric 105. Figure 9b-2 shows an example where the directional etch just exposes an upward facing surface of diffusion region 103. Note here that the etch may be modified to remove both dielectric 105 as well as the remnant of etch stop 851. Figure 9b-3 shows an example where the directional etch removes dielectric material 105 on only top and right-side surfaces of the upper diffusion region 103 and stops at the bottom of region 103. Figure 9b-4 shows how the dielectric 105 has been removed with a directional etch down to an upward facing surface of diffusion region 107, and how the contact etch stop structure 851 has been removed via an isotropic etch (designated with curvilinear arrows). Note the remnant of etch stop structure 851, along the right-side of diffusion region 107. The previous relevant discussion with respect to such remnants, as well as with respect to the selectivity of the anisotropic and isotropic etches, is equally applicable here.

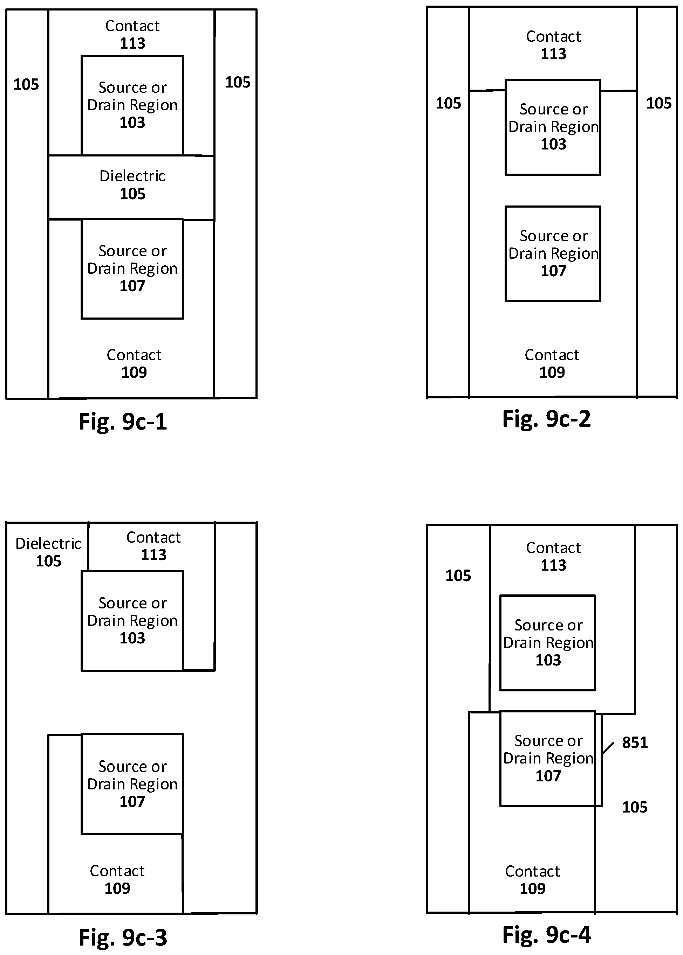

As can be seen in Figures 9c-1 through 8d-4, a backside wrap-around contact 113 has been formed. In Figure 9c-1, the wrap-around contact 113 is on top and side surfaces of the lower diffusion region 103, and sits on dielectric layer 105. In this example case, there is no common contact between the upper and lower diffusion regions 107 and 103. The example of Figure 9c-2 shows an example case where the backside contact 113 is mostly on an upward facing surface of diffusion region 103, and further lands on contact 109, to provide a common contact structure. In Figure 9c-3, the wrap-around contact 113 is on top and right-side surfaces of the diffusion region 103. In Figure 9c-4, the wrap-around contact 113 is on top, bottom and side surfaces of the diffusion region 103, as well as on an upward facing surface of diffusion region 107 and a relatively small portion of contact 109, so as to provide another example of a common contact structure. Note the remnant of the contact etch stop 851 along the side surface of diffusion region 103, which may remain intact in the final integrated circuit structure.

### Example System

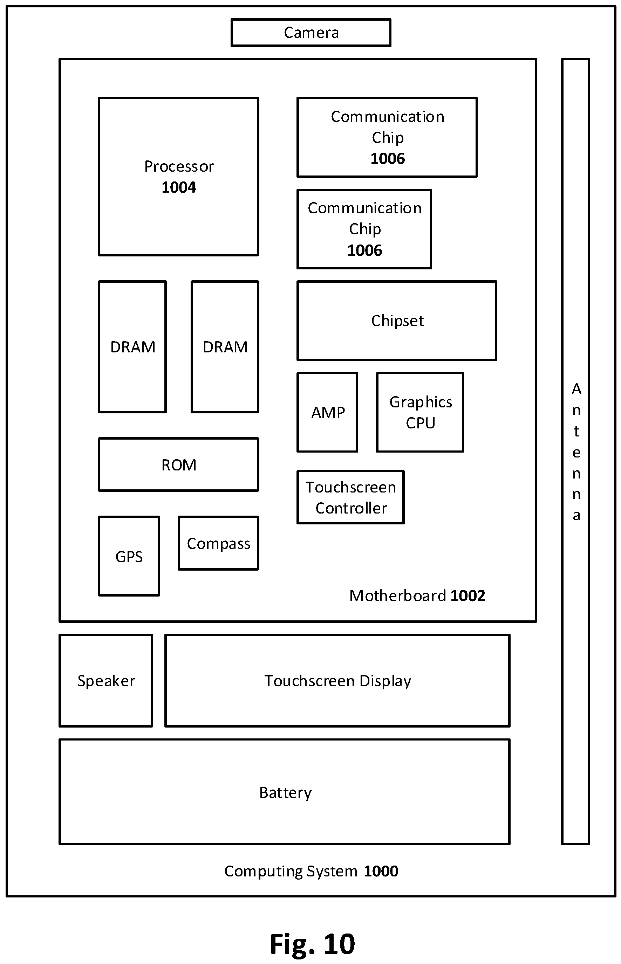

Figure 10 illustrates a computing system including one or more integrated circuits, as variously described herein, in accordance with an embodiment of the present disclosure. As can be seen, the computing system 1000 houses a motherboard 1002. The motherboard 1002 may include a number of components, including, but not limited to, a processor 1004 and at least one communication chip 1006, each of which can be physically and electrically coupled to the motherboard 1002, or otherwise integrated therein. The motherboard 402 may be, for example, any printed circuit board (PCB), whether a main board, a daughterboard mounted on a main board, or the only board of system 1000, according to some examples.

Depending on its applications, computing system 1000 may include one or more other components that may or may not be physically and electrically coupled to the motherboard 1002. These other components may include, but are not limited to, volatile memory (e.g., DRAM), nonvolatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1000 may include one or more integrated circuit structures or devices configured in accordance with an example embodiment (e.g., a module including an integrated circuit device having frontside and/or backside wrap-around contacts, as variously provided herein). In some embodiments, multiple functions can be integrated into one or more chips (e.g., for instance, note that the communication chip 1006 can be part of or otherwise integrated into the processor 1004).

The communication chip 1006 enables wireless communications for the transfer of data to and from the computing system 1000. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1006 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1000 may include a plurality of communication chips 1006. For instance, a first communication chip 1006 may be dedicated to shorter range wireless communications such as Wi-Fi and Bluetooth and a second communication chip 1006 may be dedicated to longer range wireless communications such as GPS, EDGE, GPRS, CDMA, WiMAX, LTE, Ev-DO, and others.

The processor 1004 of the computing system 1000 includes an integrated circuit die packaged within the processor 1004. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 1006 also may include an integrated circuit die packaged within the communication chip 1006. In accordance with some such example embodiments, the integrated circuit die of the communication chip includes one or more semiconductor devices as variously described herein. As will be appreciated in light of this disclosure, note that multi-standard wireless capability may be integrated directly into the processor 1004 (e.g., where functionality of any chips 406 is integrated into processor 1004, rather than having separate communication chips). Further note that processor 1004 may be a chip set having such wireless capability. In short, any number of processor 1004 and/or communication chips 1006 can be used. Likewise, any one chip or chip set can have multiple functions integrated therein.

In various implementations, the computing system 1000 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 1000 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes: a first source or drain region; a second source or drain region spaced from and over the first source or drain region; and a conductive contact on a top surface of the second source or drain and extending down a side surface of the second source or drain region such that the conductive contact is laterally adjacent to a bottom surface of the second source or drain region.

Example 2 includes the integrated circuit of Example 1, wherein the conductive contact is also on a top surface of the first source or drain region.

Example 3 includes the integrated circuit of Example 1 or 2, wherein the conductive contact also extends down a side surface of the first source or drain region.

Example 4 includes the integrated circuit of any one of Examples 1 through 3, wherein the side surface of the second source or drain region is a first side surface of the second source or drain region, the conductive contact also extending down a second side surface of the second source or drain region such that the conductive contact is laterally adjacent to the bottom surface of the second source or drain region on both the first and second side surfaces of the second source or drain region.

Example 5 includes the integrated circuit of any one of Examples 1 through 4, wherein the conductive contact is a first conductive contact, the integrated circuit comprising a second conductive contact on a bottom surface of the first source or drain region.

Example 6 includes the integrated circuit of Example 5, wherein the first conductive contact is electrically isolated from the second conductive contact.

Example 7 includes the integrated circuit of Example 5 or 6, wherein the second conductive contact also extends up a side surface of the first source or drain region such that the second conductive contact is laterally adjacent to a top surface of the first source or drain region.

Example 8 includes the integrated circuit of Example 7, wherein the second conductive contact is also on a bottom surface of the second source or drain region.

Example 9 includes the integrated circuit of Example 7 or 8, wherein the side surface of the first source or drain region is a first side surface of the first source or drain region, the second conductive contact also extending up a second side surface of the first source or drain region such that the second conductive contact is laterally adjacent to the top surface of the first source or drain region on both the first and second side surfaces of the first source or drain region.

Example 10 includes the integrated circuit of any one of Examples 1 through 9, and includes an isolation structure between first source or drain region and the second source or drain region.

Example 11 is a stacked transistor structure, comprising: a first nanoribbon; a second nanoribbon; a first gate structure wrapped around the first nanoribbon; a second gate structure wrapped around the second nanoribbon; a first source or drain region laterally adjacent to the first gate structure and in contact with the first nanoribbon; a second source or drain region spaced from and over the first source or drain region, the second source or drain region laterally adjacent to the second gate structure and in contact with the second nanoribbon; and a conductive contact on a top surface of the second source or drain and extending down a side surface of the second source or drain region such that the conductive contact is laterally adjacent to a bottom surface of the second source or drain region.

Example 12 includes the stacked transistor structure of Example 11, wherein the conductive contact is also on a top surface of the first source or drain region.

Example 13 includes the stacked transistor structure of Example 11 or 12, wherein the conductive contact also extends down a side surface of the first source or drain region.

Example 14 includes the stacked transistor structure of any one of Examples 11 through 13, wherein the side surface of the second source or drain region is a first side surface of the second source or drain region, the conductive contact also extending down a second side surface of the second source or drain region such that the conductive contact is laterally adjacent to the bottom surface of the second source or drain region on both the first and second side surfaces of the second source or drain region.

Example 15 includes the stacked transistor structure of any one of Examples 11 through 14, wherein the conductive contact is a first conductive contact, the stacked transistor structure comprising a second conductive contact on a bottom surface of the first source or drain region.

Example 16 includes the stacked transistor structure of Example 15, wherein the first conductive contact is electrically isolated from the second conductive contact.

Example 17 includes the stacked transistor structure of Example 15 or 16, wherein the second conductive contact also extends up a side surface of the first source or drain region such that the second conductive contact is laterally adjacent to a top surface of the first source or drain region.

Example 18 includes the stacked transistor structure of Example 17, wherein the second conductive contact is also on a bottom surface of the second source or drain region.

Example 19 includes the stacked transistor structure of Example 17 or 18, wherein the side surface of the first source or drain region is a first side surface of the first source or drain region, the second conductive contact also extending up a second side surface of the first source or drain region such that the second conductive contact is laterally adjacent to the top surface of the first source or drain region on both the first and second side surfaces of the first source or drain region.

Example 20 includes the stacked transistor structure of any one of Examples 11 through 19, and includes an isolation structure between first source or drain region and the second source or drain region.

Example 21 is an integrated circuit comprising: a first epitaxial source or drain region having a first maximum span, the first maximum span being the longest horizonal distance between opposing side surfaces of the first epitaxial source or drain region; a second epitaxial source or drain region spaced from and over the first epitaxial source or drain region, the second span having a second maximum span that is the longest horizonal distance between opposing side surfaces of the second epitaxial source or drain region; a conductive contact on a top surface of the epitaxial second source or drain and extending down a side surface of the second epitaxial source or drain region such that the conductive contact is laterally adjacent to a bottom surface of the second epitaxial source or drain region; wherein the first maximum span is 5 nm or more greater than the second maximum span.

Example 22 includes the integrated circuit of Example 21, wherein the conductive contact is also on a top surface of the first source or drain region.

Example 23 includes the integrated circuit of Example 21 or 22, wherein the conductive contact also extends down a side surface of the first source or drain region.

Example 24 includes the integrated circuit of any one of Examples 21 through 23, wherein the side surface of the second source or drain region is a first side surface of the second source or drain region, the conductive contact also extending down a second side surface of the second source or drain region such that the conductive contact is laterally adjacent to the bottom surface of the second source or drain region on both the first and second side surfaces of the second source or drain region.

Example 25 includes the integrated circuit of any one of Examples 21 through 24, wherein the conductive contact is a first conductive contact, the integrated circuit comprising a second conductive contact on a bottom surface of the first source or drain region.

Example 26 includes the integrated circuit of Example 25, wherein the first conductive contact is electrically isolated from the second conductive contact.

Example 27 includes the integrated circuit of Example 25 or 26, wherein the second conductive contact also extends up a side surface of the first source or drain region such that the second conductive contact is laterally adjacent to a top surface of the first source or drain region.

Example 28 includes the integrated circuit of Example 27, wherein the second conductive contact is also on a bottom surface of the second source or drain region.

Example 29 includes the integrated circuit of Example 27 or 28, wherein the side surface of the first source or drain region is a first side surface of the first source or drain region, the second conductive contact also extending up a second side surface of the first source or drain region such that the second conductive contact is laterally adjacent to the top surface of the first source or drain region on both the first and second side surfaces of the first source or drain region.

Example 30 includes the integrated circuit of any one of Examples 21 through 29, and includes an isolation structure between first source or drain region and the second source or drain region.

Example 31 is an electronic system comprising the integrated circuit of any one of Examples 1 through 10 and 21 through 30, or the stacked transistor structure of any one of Examples 11 through 20.

Example 32 is a memory chip comprising the integrated circuit of any one of Examples 1 through 10 and 21 through 30, or the stacked transistor structure of any one of Examples 11 through 20.

Example 33 is a microprocessor comprising the integrated circuit of any one of Examples 1 through 10 and 21 through 30, or the stacked transistor structure of any one of Examples 11 through 20.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a first source or drain region;
a second source or drain region spaced from and over the first source or drain region; and
a conductive contact on a top surface of the second source or drain and extending down a side surface of the second source or drain region such that the conductive contact is laterally adjacent to a bottom surface of the second source or drain region.

2. The integrated circuit of claim 1, wherein the conductive contact is also on a top surface of the first source or drain region.

3. The integrated circuit of claim 1 or 2, wherein the conductive contact also extends down a side surface of the first source or drain region.

4. The integrated circuit of any one of claims 1 through 3, wherein the side surface of the second source or drain region is a first side surface of the second source or drain region, the conductive contact also extending down a second side surface of the second source or drain region such that the conductive contact is laterally adjacent to the bottom surface of the second source or drain region on both the first and second side surfaces of the second source or drain region.

5. The integrated circuit of any one of claims 1 through 3, wherein the conductive contact is a first conductive contact, the integrated circuit comprising a second conductive contact on a bottom surface of the first source or drain region.

6. The integrated circuit of claim 5, wherein the first conductive contact is electrically isolated from the second conductive contact.

7. The integrated circuit of claim 5 or 6, wherein the second conductive contact also extends up a side surface of the first source or drain region such that the second conductive contact is laterally adjacent to a top surface of the first source or drain region.

8. The integrated circuit of claim 7, wherein the second conductive contact is also on a bottom surface of the second source or drain region.

9. The integrated circuit of claim 7 or 8, wherein the side surface of the first source or drain region is a first side surface of the first source or drain region, the second conductive contact also extending up a second side surface of the first source or drain region such that the second conductive contact is laterally adjacent to the top surface of the first source or drain region on both the first and second side surfaces of the first source or drain region.

10. The integrated circuit of any one of claims 1 through 9, comprising an isolation structure between first source or drain region and the second source or drain region.

11. A stacked transistor structure, comprising:
a first nanoribbon;
a second nanoribbon;
a first gate structure wrapped around the first nanoribbon;
a second gate structure wrapped around the second nanoribbon;
a first source or drain region laterally adjacent to the first gate structure and in contact with the first nanoribbon;
a second source or drain region spaced from and over the first source or drain region, the second source or drain region laterally adjacent to the second gate structure and in contact with the second nanoribbon; and
a conductive contact on a top surface of the second source or drain and extending down a side surface of the second source or drain region such that the conductive contact is laterally adjacent to a bottom surface of the second source or drain region.

12. The stacked transistor structure of claim 11, wherein the conductive contact is also on a top surface of the first source or drain region.

13. The stacked transistor structure of claim 11 or 12, wherein the conductive contact also extends down a side surface of the first source or drain region.

14. The stacked transistor structure of any one of claims 11 through 13, wherein the side surface of the second source or drain region is a first side surface of the second source or drain region, the conductive contact also extending down a second side surface of the second source or drain region such that the conductive contact is laterally adjacent to the bottom surface of the second source or drain region on both the first and second side surfaces of the second source or drain region.

15. The stacked transistor structure of any one of claims 11 through 14, wherein the conductive contact is a first conductive contact, the stacked transistor structure comprising a second conductive contact on a bottom surface of the first source or drain region.
